# EUROPÄISCHE PATENTANMELDUNG

(11) **EP 1 577 954 A1**
(43) Veröffentlichungstag der Anmeldung: **21.09.2005**
(21) Anmeldenummer: 04005539.4
(22) Anmeldetag: 09.03.2004
(51) Int. Cl.: H01L 31/00, C30B 15/02, C30B 29/06, C30B 35/00, B65G 53/04, B65G 53/30

(54) **Verfahren zur Förderung von Feststoffpartikeln**

(71) Anmelder: RWE SCHOTT Solar GmbH, 63755 Alzenau (DE)
(72) Erfinder: Schwirtlich, Ingo, Dr., 63987 Miltenberg (DE); von Campe, Hilmar, Dr., 61352 Bad Homburg (DE)
(74) Vertreter: Stoffregen, Hans-Herbert

(57) **Zusammenfassung**

Die Erfindung bezieht sich auf ein Verfahren zum Fördern von Feststoffpartikeln unregelmäßiger Geometrie, vorzugsweise solcher polygonaler Geometrie, durch zumindest ein Rohr, insbesondere ein oder mehrere Kurven und/oder einen oder mehrere Knicke aufweisendes Rohr oder Rohrsystem, wobei zum Fördern der Feststoffpartikel ein Fluid verwendet wird. Um dosiert im gewünschten Umfang auch Bruchstücke oder sonstige eine unregelmäßige Geometrie aufweisende Feststoffpartikel fördern zu können, ohne dass die Gefahr erwächst, dass die Partikel in dem die Partikel rührenden Rohr bzw. Rohrsystem hängen bleiben und somit zu Verstopfungen führen können, wird vorgeschlagen, dass zum Fördern der Feststoffpartikel unregelmäßiger Geometrie als erster Feststoffpartikel diesen zweite Feststoffpartikel regelmäßiger Geometrie zugegeben werden.

## Beschreibung

Die Erfindung bezieht sich auf ein Verfahren zur Förderung von Feststoffpartikeln unregelmäßiger Geometrie wie polygonaler Geometrie durch zumindest ein Rohr, insbesondere ein oder mehrere Kurven und/oder einen oder mehrere Knicke aufweisendes Rohrsystem, wobei zum Fördern der Feststoffpartikel ein Fluid verwendet wird.

In der Halbleitertechnik werden Siliciumeinkristalle für mikromechanische Bauelemente als Substrat oder für Solarzellen verwendet. Zur Herstellung der Silicium-einkristalle gelangt vorwiegend das Czochralski-Verfahren oder die Float Zone-Technik zur Anwendung. Gelegentlich wird auch das vertikale Bridgeman-Verfahren oder Züchtungstechniken aus einer metallischen Lösung wie in der Flüssigphasenepitaxie verwendet.

In der Solarzellenfertigung wird Silicium in Form dicker Blöcke mit verschiedenen Block-Kristallisations-Verfahren hergestellt. Dabei entstehen durch einfaches Abkühlen oder durch gerichtetes Erstarren der Schmelze grobkristalline Silicium-Blöcke mit Korngrößen im Bereich von 1 mm bis zu einigen Zentimetern.

Auch ist es bekannt, Silicium aus schmelzflüssiger Phase direkt in Form einer Scheibe mit definiert eingestellter Dicke kristallisieren zu lassen. Bei diesem Verfahren handelt es sich um sogenannte Bandziehverfahren, zu denen das "Edge-Defined Film-fed Growth" der RWE Schott Solar GmbH, das lineare Bandziehverfahren "Continous String Ribbon Growth" von Evergreen Solar Inc. sowie das "Ribbon Growth on Substrates"-Verfahren der Bayer AG gehören.

Bei Bandziehverfahren ist die Befüllung von sogenannten Kristallzüchtungstiegeln mit Ausgangsmaterial von Wichtigkeit, um aus der in dem Tiegel vorhandenen Siliciumschmelze die Siliciumscheiben reproduzierbar ziehen zu können. Bei Anlagen einfacher Bauart werden entsprechende Kristallzüchtungstiegel mit mehrere Zentimeter großen Granulatkömem, dem sogenannten PolySilicium von Hand befüllt. Dieses PolySilicium weist einen hohen Reinheitsgrad auf. Bei Wiederverwendung von Silicium, das eine geringere Reinheit aufweist und vor allem wegen des niedrigen Materialpreises zur Herstellung von Solarzellen eingesetzt wird, werden Bruchstücke wie rezyklierte Wafer, fehlerhafte Kristalle oder Sägeabschnitte wie Tops und Tails sowie Seiten- und Randstücke von nach dem Czochralski-Verfahren oder Float-Zone-Technik-Verfahren hergestellten Kristallen oder Abschnitte von Blockgussmaterial, fehlerhafte PolySiliciumstäbe oder ähnliches auf diese Weise wieder verwendet.

Durchlaufverfahren, bei denen kristallines Ausgangsmaterial in fester oder flüssiger Form dem Schmelztiegel zugeführt wird, während die Kristallzüchtung erfolgt, sind vor allem beim Czochalski-Verfahren und beim Edge-Defined Film-fed Growth-Verfahren bekannt. Allerdings erfordert die kontinuierliche Zuführung kleinere Kristallpartikel von der Größenordnung einiger Millimeter, die während des Kristallisationsvorganges in dem Umfang der Schmelze zugeführt werden müssen, wie Material durch den wachsenden Kristall aus der Schmelze entfernt wird.

Nach dem Stand der Technik werden sphärische Siliciumpartikel, die bei hohen Temperaturen aus einem Wirbelbett mittels CVD-Abscheidung von Silan bei einer Temperatur zwischen 600 °C und 900 °C oder von Trichlorsilan bei einer Temperatur von 1000 °C bis 1300 °C in reduzierendem Wasserstoff abgeschieden werden, benutzt. In größerem Maßstab lieferbar sind zur Zeit die aus Silan abgeschiedenen Partikel. Wegen der hohen Reinheitsanforderungen von Seiten der Halbleiterindustrie sind diese jedoch sehr teuer.

Bei der kontinuierlichen Nachbefüllung der Kristallzüchtungstiegel ist der Nachteil gegeben, dass auf Grund der erforderlichen thermischen Abschirmung der Zugang zum Kristallzüchtungstiegel - der auch als Schmelztiegel bezeichnet werden kann - erschwert ist. Somit sind spezielle Transporttechniken in einem speziellen Rohrsystem erforderlich. Dabei werden nach dem Stand der Technik sphärische Partikel definierter Größe über Rinnen oder durch die Schwerkraft mittels eines Gasstroms in einem Rohr dem Tiegel zugeführt.

Der vorliegenden Erfindung liegt das Problem zu Grunde, ein Verfahren der eingangs genanten Art so weiterzubilden, dass wohl dosiert im gewünschten Umfang auch Bruchstücke oder sonstige eine unregelmäßige Geometrie aufweisende Feststoffpartikel gefördert werden können, ohne dass die Gefahr erwächst, dass die Partikel in dem die Partikel führenden Rohr bzw. Rohrsystem hängen bleiben und somit zu Verstopfungen führen können.

Zur Lösung des Problems wird im Wesentlichen vorgeschlagen, dass zum Fördern der Feststoffpartikel unregelmäßiger Geometrie als erste Feststoffpartikel diesen zweite Feststoffpartikel regelmäßiger Geometrie zugegeben werden.

Erfindungsgemäß werden zum Fördern der Feststoffpartikel unregelmäßiger Geometrie als Trägermedium neben dem Förderfluid, das vorzugsweise ein Gas ist, zweite Feststoffpartikel zugegeben, die eine regelmäßige wie Kugel- oder Ellipsoidgeometrie aufweisen. Diese bewirken eine verbesserte Fließfähigkeit der ersten Feststoffpartikel, so dass in Folge dessen sichergestellt ist, dass im erforderlichen Umfang und dosiert z.B. Siliciumpartikel einer Schmelze zugeführt werden können. Somit eröffnet sich z.B. die Möglichkeit, kostengünstige Siliciumpartikel wie Kristall-Bruchstücke, rezyklierte gebrochene Wafer, gebrochene fehlerhafte Kristalle oder Sägeabschnitte, um nur einige Beispiele zu nennen, zu verwenden, die geschmolzen werden.

Die erfindungsgemäße Lehre bietet ein Förderverfahren für Partikel wie gebrochenes Granulat beliebiger Form mit einer breiten Korngrößenverteilung. Dabei besteht die Möglichkeit ein Knicke und Bögen aufweisendes Rohrsystem zu verwenden, ohne dass die Gefahr eines Verstopfens erwächst. Es werden folglich im Fall der Kristallzüchtung regelmäßig geformte sphärische Siliciumpartikel mit unregelmäßig geformten Bruchstücken aus Silicium in einen Tiegel gefördert. Unter unregelmäßig geformte Bruchstücke können dabei Granulate, Körner oder scheibchenförmige Teilchen aus gebrochenem Siliciummaterial subsumiert werden. Als Ausgangsprodukte sind CVD-Poly-Siliciumstäbe, Bruchstücke von multikristallinen Blöcken, Bruch- und Endstücke von Siliciumeinkristallen sowie Bruchstücke von mono- oder multikristallinen Wafern zu nennen.

Förderrate und Gleichmäßigkeit der Förderung hängt von den Anteilen zwischen großen und kleinen Partikeln ab. Dabei nimmt die Förderrate mit zunehmendem Anteil an unregelmäßig geformtem Material linear ab. Besonders gute Förderergebnisse lassen sich dann erzielen, wenn der Anteil der ersten Feststoffe, als die Partikel, die eine unregelmäßige Außengeometrie aufweisen, in etwa 1 % bis in etwa 50 % von der Gesamtmenge der ersten und zweiten Feststoffpartikel beträgt.

Die ersten Partikel sollten des Weiteren eine Korngröße zwischen 0,3 mm bis 5 mm, vorzugsweise im Bereich zwischen 0,5 mm und 2 mm aufweisen.

Um den Einfluss von Ecken und Kanten im Rohrsystem zu minimieren, sollte das Längen-und Breitenverhältnis des Granulates < 3 betragen. Unabhängig hiervon wird die Fließfähigkeit mit der Zunahme des Anteils an den zweiten, also sphärischen Partikeln erhöht.

Ursächlich für die Verringerung der Förderrate bei einem Längen-Breitenverhältnis > 3 für die ersten Feststoffpartikel dürfte sein, dass in diesem Falle Granulatkörner verhaken können und somit das Rohr bzw. Rohrsystem, durch das die Partikel gefördert werden, verstopfen kann. Werden jedoch entsprechende längliche Körper mit einem Längen-Breitenverhältnis < 3 mit kleinerem fließfähigen Material, also den zweiten eine sphärische Geometrie aufweisenden Partikeln gleichmäßig vermischt, so verbessert sich die Förderrate, da in diesem Fall die ersten Feststoffpartikel quasi von den zweiten Feststoffpartikeln umgeben und mittels dieser gefördert werden.

Des Weiteren sieht die Erfindung vor, dass die ersten Feststoffpartikel eine maximale Länge L aufweist, die gleich oder kleiner als Radius des Rohres bzw. Rohrsystems ist, durch das die Partikel gefördert werden.

Eine Verbesserung der Förderfähigkeit ergibt sich dann, wenn gezielt Fluidpakete wie Gas-oder Flüssigpakete zur Förderung zugegeben werden, wodurch die Partikel durch das Fluid aufgelockert werden. Die geförderten Ansammlungen von Feststoffpartikeln erfahren hierdurch eine Änderung ihrer relativen Anordnung zueinander, so dass Hindernisse wie Bögen, Ecken oder Kanten bzw. raue und unebene Oberflächen des Rohres bzw. Rohrsystems besser überwunden werden können. Somit wird die Fließfähigkeit des Materials erhöht. Daher sieht eine Weiterbildung der Erfindung vor, dass das Fluid dem Rohr gepulst zugeführt wird. Auch besteht die Möglichkeit, dass die Feststoffpartikel in Abschnitten des Rohrsystems beschleunigt werden. Unabhängig davon ist bevorzugterweise vorgesehen, dass als Fluid ein Gas bestehend aus Pressluft, Stickstoff, Argon und/oder Kohlendioxid oder eine Mischung dieser verwendet wird.

Eine weitere hervorzuhebende Ausgestaltung der Erfindung sieht vor, dass die in eine Siliciumschmelze zugeführten Feststoffpartikel zur Dotierung der Schmelze dienen. Mit anderen Worten wird die Siliciumschmelze mittels insbesondere in den ersten Feststoffpartikeln vorhandener Dotierelemente dotiert. Hierzu können hochdotierte Siliciumkörner aus dotierten Reststücken durch Zerkleinerung hergestellt und entsprechend der gewünschten Dotierung in den zu ziehenden Kristallen anteilig im Verhältnis unter undotierte Feststoffpartikel gemischt werden, die vorzugsweise sphärische, also Kugelgeometrie aufweisen.

Als Dotierstoffe können bor- und/oder phosphordotierte Materialien eingesetzt werden. Aber auch andere Elemente der 3. Gruppe des Periodensystems wie Al, Ga, In und/oder der 5. Gruppe des Periodensystems wie As, Sb können verwendet werden.

Mit entsprechenden Maßnahmen können Dotierkonzentrationen in der Größenordnung zwischen 1 · 10¹⁷ cm³ bis 1 · 10²⁰ cm³, vorzugsweise 1 · 10¹⁸ cm³ bis 1 · 10¹⁹ cm³ erzeugt werden.

Insbesondere zeichnet sich die Erfindung durch ein kontinuierliches Verfahren zur Herstellung von festem Silicium durch Kristallisation des Siliciums aus einer Siliciumschmelze, insbesondere zur Herstellung von Siliciumscheiben nach dem Edge-Defined Film-fed Growth (EFG)-Verfahren, wobei entsprechend aus der in einem Behältnis vorhandenen Siliciumschmelze kristallisiertes Silicium der Siliciumschmelze aus Silicium bestehendes oder dieses enthaltendes Feststoffmaterial zugeführt wird, dadurch aus, dass das Feststoffmaterial aus ersten und zweiten Feststoffpartikeln besteht oder diese zumindest enthält, dass die ersten Feststoffpartikel aus gebrochenem Silicium bestehen und die zweiten Feststoffpartikel eine sphärische Geometrie aufweisen und dass das Feststoffmaterial mittels eines Fluids gefördert wird. Dabei wird das Feststoffmaterial durch ein Rohr gefördert, das die Schmelze mittig durchsetzt oder von dieser konzentrisch umgeben ist. Die Feststoffpartikel werden über ein oberhalb des Rohres angeordnetes Kegelgeometrie aufweisendes Umlenkelement in Richtung des Behälters umgelenkt. Ferner werden die Feststoffpartikel über ein das Rohr umgebendes außenrandseitig im Bereich der Schmelze verlaufendes eine Kugeloberflächenabschnittgeometrie aufweisendes Abweiselement in die Schmelze geleitet.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmendem bevorzugten Ausführungsbeispiel.

Es zeigen:
- Fig. 1: eine Prinzipdarstellung einer Anordnung zum Zuführen von Siliciumpartikeln in eine Schmelze und
- Fig. 2: ein Diagramm einer partikelabhängigen Förderrate.

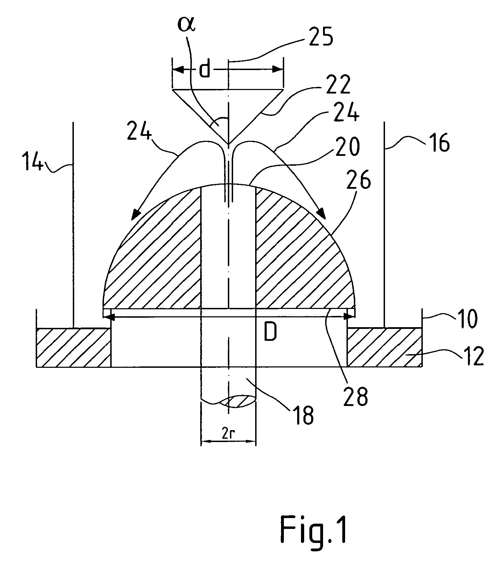

In Fig. 1 ist rein prinzipiell ein Anordnung dargestellt, mittels der aus Silicium bestehende oder Silicium enthaltende Feststoffpartikel einer in einem als Rinne 10 ausgebildeten Schmelztiegel vorhandenen Siliciumschmelze 12 zugeführt werden.

Aus der Rinne 10 bzw. der Siliciumschmelze 12 wird nach dem Edge-Defined Film-fed Growth (EFG)-Bandziehverfahren ein Hohlkörper aus kristallisiertem Silicium gezogen. Abschnitte, also scheibenförmige Flächenanteile des Hohlkörpers sind mit den Bezugszeichen 14 und 16 gekennzeichnet. Um in Abhängigkeit von der Menge des aus der Schmelze 12 kristallisierten Silicium Siliciumpartikel wohl dosiert zuzuführen, ist ein einen Rohrabschnitt 18 umfassendes Rohrsystem vorgesehen, durch das die Siliciumpartikel insbesondere mittels eines Gasfluides gefördert werden. Das Rohr 18 verläuft entlang der gedachten Symmetrielinie 25 der Rinne 10. Oberhalb des Rohres 18 bzw. dessen Öffnung 20 ist ein Umlenkelement 22 angeordnet, das die Geometrie eines auf den Kopf gestellten Kegels aufweist. Aus dem Rohr 18 beförderte Partikel werden demzufolge bei Auftreffen auf das Umlenkelement 22 umgelenkt (Pfeils 24), um sodann über ein Abweiselement 26 der Schmelze 12 zugeführt zu werden. Das Abweiselement 26 umgibt konzentrisch das Rohr 18 und weist eine Kegeloberflächenabschnittsgeometrie, also quasi eine Schirmgeometrie auf, deren peripherer Rand 28 oberhalb der Schmelze 12 endet. Hierdurch ist sichergestellt, dass die entlang der Oberfläche des Abweiselementes 26 geführten Siliciumpartikel gezielt in die Schmelze 12 gelangen, ohne dass die Gefahr besteht, dass ein Auftreffen auf den Hohlkörper aus kristallisiertem Silicium erfolgt.

Das Siliciummaterial besteht aus ersten und zweiten Siliciumpartikeln, von denen erste Partikel eine unregelmäßige Geometrie und zweite Partikel eine sphärische Geometrie aufweisen. Durch die Mischung der ersten und zweiten Siliciumpartikel ist sichergestellt, dass ein problemloses Fördern der eine unregelmäßige Geometrie aufweisenden ersten Partikel durch das Bögen und gegebenenfalls Abwinkelungen aufweisende Rohrsystem erfolgt, ohne dass die Gefahr eine Verhakens der Partikel untereinander oder eines Ablagems in dem Rohr erfolgt. Dies bewirken die zweiten Siliciumpartikel, die quasi als Trägersubstanz für die ersten Siliciumpartikel dienen. Als erste Siliciumpartikel kommt insbesondere gebrochenes Siliciummaterial in Frage. So können als Ausgangsstücke CVD-PolySiliciumstäbe, Bruchstücke von multikristallinen Blöcken, Bruch- und Endstücke von Siliciumeinkristallen sowie Bruchstücke von mono- und multikristallinen Wafern verwendet werden. Hierdurch bedingt kann relativ kostengünstiges Siliciumausgangsmaterial benutzt werden, um den Siliciumhohlkörper zu ziehen.

Ferner ergibt sich der Vorteil, dass die eine unregelmäßige Oberflächengeometrie aufweisenden ersten Siliciumpartikel aus dotierten Reststücken bestehen können, wodurch eine gezielte Dotierung der Schmelze 12 erfolgen kann. Als Dotierstoffe kommen Bor und Phosphor aber auch Element der 3. Gruppe des Periodensystems wie Al, Ga, In oder der 5. Gruppe des Periodensystems wie As und Sb in Frage. Insbesondere ist durch gezieltes mengenmäßiges Vermischen der ersten die Dotierstoffe enthaltenden Partikel mit den zweiten Partikeln die Möglichkeit gegeben, die Dotierkonzentration in der Schmelze 12 auf 1 · 10¹⁷ cm³ bis 1 · 10²⁰ cm³, vorzugsweise im Bereich von 1 · 10¹⁸ cm³ bis 1 · 10¹⁹ cm³ kostengünstig einzustellen.

Um die Förderfähigkeit zu erhöhen, kann als Förderfluid ein insbesondere gepulstes Gas benutzt werden, das durch das Rohrsystem geschickt wird. Auch kann über Anschlüsse in dem Rohrsystem oder Veränderungen des Rohrquerschnitts ein abschnittsweises Beschleunigen der Partikel erfolgen, wodurch eine zusätzliche Vermischung der Partikel untereinander erfolgt, wodurch die Fließfähigkeit verbessert werden kann.

Die Siliciumpartikel unregelmäßiger Geometrie sollten ein maximales Längen- zu Breitenverhältnis < 3 aufweisen. Des Weiteren sollte die maximale Länge kleiner als der Radius des Rohres 18 bzw. minimaler Radius eines in dem Rohrsystem vorhandenen Abschnitts sein.

Des Weiteren ist vorgesehen, dass die Temperatur des Abweisers 26 bzw. Umlenkelementes 22 im Bereich zwischen 300 °C und 1200 °C, bevorzugterweise zwischen 1000 °C und 1120 °C liegt. Durch diese Maßnahmen wird sichergestellt, dass die Schmelze 12 beim Eintauchen der Partikel eine Temperaturänderung nicht in einem Umfang erfährt, der die Güte des zu ziehenden Hohlkörpers 14, 16 beeinflusst.

Des Weiteren sollten das eine Kegelgeometrie aufweisende Umlenkelement und das Abweiselement 26 in ihrer Geometrie auf die Morphologie und das Mischungsverhältnis der Feststoffpartikel abgestimmt sein.

Längliche Partikel mit einer Breite B und einer Länge L sollten derart dimensioniert sein, dass die Länge L ≤ 3B ist. Ferner sollte der Krümmungsradius des Rohres, in dem die Partikel transportiert werden, mindestens sechsfacher Breite B entsprechen.

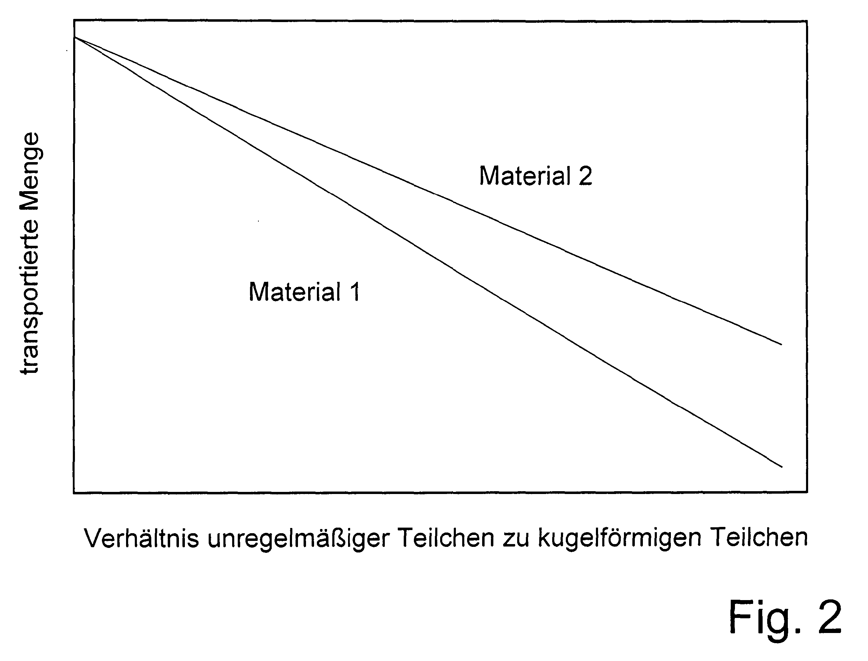

Förderrate der der Schmelze 12 zuzuführenden Siliciumpartikel hängt von dem Verhältnis zwischen ersten und zweiten Siliciumpartikeln ab. Dies wird an Hand der Fig. 2 verdeutlicht. In dieser ist transportierte Menge im Verhältnis unregelmäßiger Teilchen zu kugelförmigen Teilchen dargestellt. Dabei weist das Material 1 unregelmäßigere zweite Teilchen als das Material 2 auf. Sind keine unregelmäßigen Feststoffpartikel in der zu fördernden Mischung enthalten, so ist die pro Einheit transportierte Menge gleich. Mit zunehmendem Anteil von Feststoffpartikeln unregelmäßiger Geometrie nimmt die transportierte Menge pro Zeiteinheit ab, wobei die Mischung, die unregelmäßigere Feststoffpartikel enthält, einen stärkeren Abfall zeigt.

Der Winkel α des eine Kegelform aufweisenden Abweisers 22 beläuft sich auf ≤ α ≤60°, insbesondere α = 45°. Der Durchmesser in der Basisfläche beläuft sich auf d. Demgegenüber weist der Abweiser 26 an der Basis einen Durchmesser D auf. Unter Berücksichtigung dieser geometrischen Bedingungen sollte 0,2 ≤ d/D < 0,8 betragen.

## Patentansprüche

1. Verfahren zum Fördern von Feststoffpartikeln unregelmäßiger Geometrie, vorzugsweise solcher polygonaler Geometrie, durch zumindest ein Rohr, insbesondere ein oder mehrere Kurven und/oder einen oder mehrere Knicke aufweisendes Rohr oder Rohrsystem, wobei zum Fördern der Feststoffpartikel ein Fluid verwendet wird,
**dadurch gekennzeichnet,**
**dass** zum Fördern der Feststoffpartikel unregelmäßiger Geometrie als erste Feststoffpartikel diesen zweite Feststoffpartikel regelmäßiger Geometrie zugegeben werden.

2. Verfahren nach Anspruch 1,
**dadurch gekennzeichnet,**
**dass** als zweite Feststoffpartikel solche mit sphärischer oder ellipsoider Geometrie zugegeben werden.

3. Verfahren nach Anspruch 1 oder 2,
**dadurch gekennzeichnet,**
**dass** Anteil der ersten Feststoffpartikel in etwa 1 % bis in etwa 50 % von Gesamtmenge der ersten und zweiten Feststoffpartikel beträgt.

4. Verfahren nach zumindest einem der vorhergehenden Ansprüche,
**dadurch gekennzeichnet,**
**dass** als Fluid Gas oder Flüssigkeit verwendet wird.

5. Verfahren nach zumindest einem der vorhergehenden Ansprüche,
**dadurch gekennzeichnet,**
**dass** die Feststoffpartikel mittels Fluidpaketen gefördert werden.

6. Verfahren nach zumindest einem der vorhergehenden Ansprüche,
**dadurch gekennzeichnet,**
**dass** das Fluid gepulst dem Rohr bzw. Rohrsystem zugeführt wird.

7. Verfahren nach zumindest einem der vorhergehenden Ansprüche,
**dadurch gekennzeichnet,**
**dass** das Fluid in regelmäßigen oder unregelmäßigen Zeitabständen gepulst wird.

8. Verfahren nach zumindest einem der vorhergehenden Ansprüche,
**dadurch gekennzeichnet,**
**dass** die ersten Feststoffpartikel eine längliche Form mit einer Breite B und einer Länge L mit einem Längen- zu Breitenverhältnis von L: B in etwa ≤ 3 aufweisen.

9. Verfahren nach zumindest einem der vorhergehenden Ansprüche,
**dadurch gekennzeichnet,**
**dass** die Länge L der ersten Feststoffpartikel maximal Radius des Rohres ist.

10. Verfahren nach zumindest einem der vorhergehenden Ansprüche,
**dadurch gekennzeichnet,**
**dass** die ersten und die zweiten Feststoffpartikel aus Silicium bestehen oder dieses enthalten.

11. Verfahren nach zumindest einem der vorhergehenden Ansprüche,
**dadurch gekennzeichnet,**
**dass** als erste Feststoffpartikel gebrochenes Siliciummaterial wie Bruchstücke von CVD-Poly-Siliciumstäbe, Bruchstücke von multikristallinen Blöcken, Bruch-und/oder Endstücke von Siliciumeinkristallen, Bruchstücke von mono- und/oder multikristallinen Wafern verwendet werden.

12. Verfahren nach zumindest einem der vorhergehenden Ansprüche,
**dadurch gekennzeichnet,**
**dass** die Feststoffpartikel einer Siliciumschmelze zugeführt werden.

13. Verfahren nach zumindest einem der vorhergehenden Ansprüche,
**dadurch gekennzeichnet,**
**dass** die Siliciumschmelze mittels in den ersten Feststoffpartikeln vorhandenet Dotierelemente dotiert wird.

14. Verfahren nach zumindest einem der vorhergehenden Ansprüche,
**dadurch gekennzeichnet,**
**dass** als Dotierelemente Bor, Phosphor, Elemente der 3. Gruppe und/oder der 5. Gruppe des Periodensystems verwendet werden.

15. Verfahren nach zumindest einem der vorhergehenden Ansprüche,
**dadurch gekennzeichnet,**
**dass** hochdotierte erste Feststoffpartikel mit undotierten zweiten Feststoffpartikeln in einem Verhältnis der Schmelze zugeführt werden, dass in dieser eine Dotierkonzentration C mit 1 · 10¹⁷ cm³ ≤ C ≤ 1 · 10²⁰ cm³, insbesondere 1 · 10¹⁸ cm³ bis 1 · 10¹⁹ cm³ herrscht.

16. Verfahren zur Herstellung von festem Silicium durch Kristallisation des Silicium aus einer Siliciumschmelze, insbesondere zum Herstellen von Siliciumscheiben nach dem Edge-Defined Film-fed Growth-Bandziehverfahren, wobei entsprechend aus der in einem Behältnis wie Tiegel vorhandenen Siliciumschmelze gezogenes kristallisiertes Silicium der Siliciumschmelze aus Silicium bestehendes oder dieses enthaltendes Feststoffmaterial zugeführt wird,
**dadurch gekennzeichnet,**
**dass** das Feststoffmaterial aus ersten und zweiten Feststoffpartikeln besteht oder diese zumindest enthält, dass die ersten Feststoffpartikel aus gebrochenem Siliciummaterial bestehen und die zweiten Feststoffpartikel eine sphärische oder ellipsoide Geometrie aufweisen und dass das Feststoffmaterial mittels eines Fluids gefördert wird.

17. Verfahren nach Anspruch 16,
**dadurch gekennzeichnet,**
**dass** das Feststoffmaterial durch ein Rohr gefördert wird, das die Schmelze mittig durchsetzt oder von dieser konzentrisch umgeben ist, dass die Feststoffpartikel über ein oberhalb des Rohres angeordnetes Kegelgeometrie aufweisendes Umlenkelement in Richtung des Behälters umgelenkt werden und dass die Feststoffpartikel über ein das Rohr umgebendes außenrandseitig im Bereich der Schmelze verlaufendes eine Kugeloberflächenabschnittgeometrie aufweisendes Abweiselement in die Schmelze geleitet werden.

18. Verfahren nach zumindest einem der vorhergehenden Ansprüche,
**dadurch gekennzeichnet,**
**dass** als Fluid ein Gas bestehend aus Pressluft, Stickstoff, Argon und/oder Kohlendioxid oder eine Mischung dieser verwendet wird.

19. Verfahren nach zumindest einem der vorhergehenden Ansprüche,
**dadurch gekennzeichnet,**
**dass** die Feststoffpartikel abschnittsweise in dem Rohrsystem beschleunigt werden.

20. Verfahren nach zumindest einem der vorhergehenden Ansprüche,
**dadurch gekennzeichnet,**
**dass** das die Kegelgeometrie aufweisende Umlenkelement und das Abweiselement in ihrer Geometrie auf die Morphologie und das Mischungesverhältnis der Feststoffpartikel abgestimmt sind.

21. Verfahren nach zumindest einem der vorhergehenden Ansprüche,
**dadurch gekennzeichnet,**
**dass** die Temperatur von Abweiser und/oder Umlenkelement im Bereich von 300 °C bis 1200 °C, bevorzugt zwischen 1000 °C und 1120 °C eingestellt wird.

22. Verfahren nach zumindest einem der vorhergehenden Ansprüche,
**dadurch gekennzeichnet,**
**dass** das die Kegelgeomtrie aufweisende Umlenkelement einen Öffnungswinkel α mit vorzugsweise 30° ≤ α ≤ 60°, insbesondere α in etwa 45° und an seiner Basis einen Durchmesser d und das Abweiselement an seiner Basis einen Durchmesser D mit 0,2 ≤ d/D ≤ 0,8 aufweisen.
